# EUROPÄISCHE PATENTSCHRIFT

(11) **EP 0 732 424 B1**
(45) Veröffentlichungstag und Bekanntmachung des Hinweises auf die Patenterteilung: **30.06.1999**
(21) Anmeldenummer: 96103716.5
(22) Anmeldetag: 09.03.1996
(51) Int. Cl.: C23F 1/08

(54) **Verfahren und Vorrichtung zum Behandeln von plattenförmigen Gegenständen, insbesondere Leiterplatten**
Method and apparatus for treating plate like articles, in particular printed circuit boards
Méthode et dispositif pour le traitement de produits en forme de plaque, e.p. des circuits imprimés

(30) Priorität: 15.03.1995 DE 19509313
(43) Veröffentlichungstag der Anmeldung: 18.09.1996
(73) Patentinhaber: Gebr. Schmid GmbH & Co., D-72250 Freudenstadt (DE)
(72) Erfinder: Schmid, Dieter C., Dipl.-Ing., D-72250 Freudenstadt-Dietersweiler (DE)
(74) Vertreter: Patentanwälte Ruff, Beier, Schöndorf und Mütschele

(56) Entgegenhaltungen:
- EP-A- 0 267 874
- EP-A- 0 269 566
- EP-A- 0 498 250
- DE-A- 2 937 388
- DE-A- 3 602 078
- US-A- 4 339 297
- US-A- 4 759 817
- IBM TECHNICAL DISCLOSURE BULLETIN, Bd. 10, Nr. 5, 1.Oktober 1967, NEW YORK US, Seiten 528-529, XP002007209 KELLER: "Ultrasonic fountain processor"
- WESTERN ELECTRIC TECHNICAL DIGEST, Nr. 30, 1.April 1973, Seiten 9-10, XP002007210 FIGULI E. S.: "Wafer plating fixture"

## Beschreibung

### Anwendungsgebiet und Stand der Technik

Die Erfindung betrifft ein Verfahren und eine Vorrichtung zum Behandeln von plattenförmigen Gegenständen mit einem flüssigen Medium, insbesondere Ätzen von Leiterplatten.

Aus dem IBM Technical Disclosure Bulletin, Bd. 10, Nr. 5, 1.10.1967, New York, USA, Seiten 528 bis 529 ist eine Behandlungsvorrichtung für Werkstücke wie Wafer mit einer Behandlungsflüssigkeit bekannt geworden, die einen Miniskus über dem Badbehälter bildet. Die Wafer werden an ihrer Oberseite mit einer Art Saugnapf gehalten, der horizontal in und aus dem Miniskus bewegt werden kann. Dabei ist die Größe der Saugnäpfe der Größe der zu behandelnden Gegenstände anzupassen. Die Arbeitsweise ist nicht kontinuierlich und die Positionierungsmechanismen für das Ergreifen und Entnehmen der Gegenstände sind aufwendig.

Ferner ist aus dem Western Electric Technical Digest, Nr. 30, 1.04.1973, Seiten 9 bis 10, eine ähnliche Vorrichtung bekannt geworden, die eine Reihe von Saugnäpfen an einer Haltevorrichtung zeigt, die zwischen verschiedenen Tanks bei einer Wafer-Beschichtungs- oder Ätzbehandlung bewegt werden können. Auch hier ist die Größe der Saugnäpfe der Größe und Form der Gegenstände anzupassen und die Bewegung der Haltevorrichtungen zwischen den Behandlungsstationen ist, insbesondere durch die Notwendigkeit des Anschlusses der Vakuumleitungen, kompliziert. Die Gegenstände werden in vertikaler Lage gehalten und von einer Seite behandelt.

Aus der EP-504 656 A1 ist ein Verfahren und eine Vorrichtung bekanntgeworden, bei denen die Behandlung der zu ätzenden Leiterplatten von der Unterseite her erfolgt. Dies ermöglicht ein sehr schnelles und wirksames Ätzen, weil die aufgebrachte Flüssigkeit unmittelbar nach ihrer Einwirkung wieder von der Oberfläche abtropfen kann und keine "Pfützen" gebildet werden, in denen eine verzögerte Reaktion auftreten könnte. Die Leiterplatten werden auf Rollenbahnen durch die Behandlungsstation geführt, durch die hindurch das Behandlungsmedium aufgebracht wird, beispielsweise durch Sprühen. Oberbänder laufen parallel zur Transportebene und verhindern ein Ausweichen der Leiterplatten nach oben. Dieses Verfahren arbeitet mit üblichen Leiterplatten ausreichender Dicke und Steifigkeit gut und störungsfrei.

### Aufgabe und Lösung

Aufgabe der Erfindung ist es, ein Verfahren und eine Vorrichtung zu schaffen, die eine wirtschaftliche Behandlung von unten bei extrem dünnen und flexiblen Gegenständen ermöglicht.

Diese Aufgabe wird durch die Ansprüche 1 und 4 gelöst. Der durch die Saugwirkung erzielte, am Förderband hängende Transport ermöglicht die Lösung zweier Probleme: Sehr dünne und sehr flexible Gegenstände, beispielsweise Leiterplatten, die bis zu einer Minimaldicke von 25 µm oder darunter verarbeitet werden, neigen bei der Bearbeitung im Durchlaufverfahren dazu, auf Rollenbahnen abgelenkt zu werden und zwischen benachbarte Rollen zu geraten, was zu ernsthaften Betriebsstörungen führt. Eine Abhilfe könnte hier nur eine immer dichtere Anordnung der in Transportrichtung aufeinanderfolgenden Rollen bringen. Teilweise müßten diese sich sogar überlappen, um keine Spalte für das Ausweichen der Leiterplatten von der Transportebene zu eröffnen. Durch den Saugtransport kann auf die Rollenbahnen ganz verzichtet werden. Der Gegenstand ist von seiner Oberseite her gehalten und hat keine Möglichkeit, von dem Förderband, gegen das ihn die Saugwirkung ansaugt, woandershin abzuweichen.

Zugleich wird ein weiteres großes Problem gelöst, das bei der Behandlung von Gegenständen mit dem Medium von unten her auftrat, nämlich die Tatsache, daß zwischen den die Gegenstände leitenden Rollenbahnen die Behandlung z.B. durch Sprühen von unten behindert wurde. Nunmehr ist der Gegenstand vollständig frei zugänglich, so daß er beliebig von seiner Unterseite behandelt werden kann.

Vorzugsweise werden beide Seiten des Gegenstandes von der Unterseite her behandelt, um das Behandlungsmedium stets frisch aufzubringen und es danach sofort abtropfen zu lassen. Dadurch wird das Behandlungsmedium stets frisch aufgebracht. Es können keine "Pfützen" entstehen, die zu einer ungleichmäßigen Behandlung führen würden. Ferner wird durch die gezielte Entfernung des Mediums durch Abfließen und/oder Abtropfen unmittelbar nach der Aufbringung die Bildung einer Schicht verbrauchten Mediums verhindert, und das vorzugsweise wiederholt neue Aufbringen von Medium in aufeinanderfolgenden Aufbringungsbereichen führt zu einer hohen Turbulenz in der Grenzschicht und dadurch zu erhöhter Reaktionsgeschwindigkeit und -gleichmäßigkeit.

Es können beispielsweise mehrere aufeinanderfolgende Reihen von Sprühdüsen vorgesehen sein, zwischen denen das Medium jeweils abfließen und/oder abtropfen kann. Die Vorrichtung kann beispielsweise ein gelochtes Förderband aufweisen, an dessen Untertrum die Gegenstände durch einen Saugkasten angesaugt werden, der mit einer Vakuumpumpe sowie ggf. mit zwischengeschaltetem Abscheider für das Medium, verbunden ist.

Um die Behandlung beider Seiten des Gegenstandes jeweils von der Unterseite her sicherzustellen, kann zwischen zwei aufeinanderfolgenden Behandlungsstationen eine Wendestation eingeschaltet sein. Es ist aber auch möglich, eine Wendestation am Auslauf nur einer Behandlungsstation vorzusehen, die Gegenstände darin um 180° zu drehen und sie in umgekehrter Transportrichtung wieder zurücklaufen zu lassen. Einzelheiten dieser doppelseitigen Behandlung jeweils von unten her sind der EP-504 656 A1 zu entnehmen, auf die hier ausdrücklich Bezug genommen wird.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird.

Die Unterteilung der Anmeldung in einzelne Abschnitte sowie Zwischen-Überschriften beschränken die unter diesen gemachten Aussagen nicht in ihrer Allgemeingültigkeit.

### Figuren-Kurzbeschreibung

Ein Ausführungsbeispiel der Erfindung ist in den Zeichnungen dargestellt und wird im folgenden näher erläutert. Die einzige
Zeichnungsfigur zeigt einen schematischen Längsschnitt durch eine Behandlungsvorrichtung.

### Beschreibung des Ausführungsbeispiels

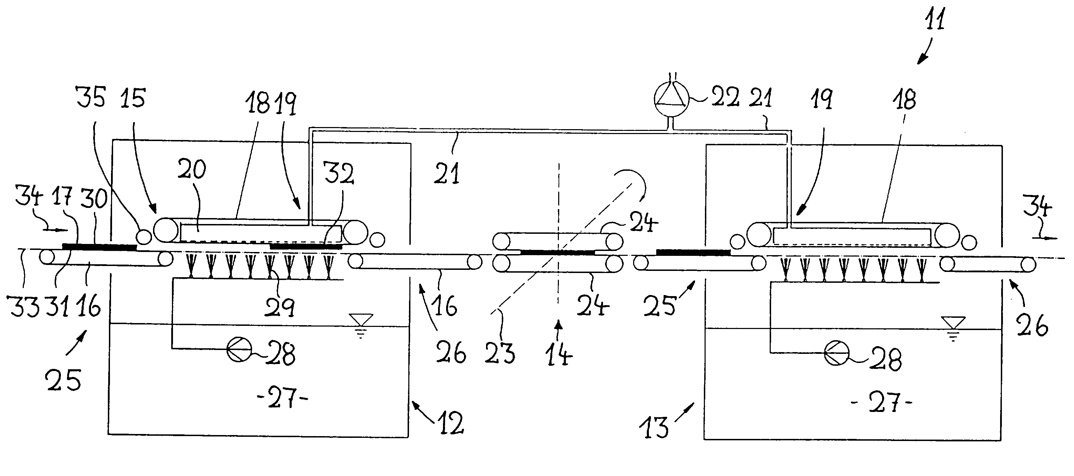

Die Zeichnung zeigt schematisch eine Behandlungsvorrichtung 11 für plattenförmige Gegenstände 17, beispielsweise elektrische Leiterplatten, d.h. mit Leiterbahnen meist auf beiden Seiten zu versehende isolierende Kunststoffplättchen. Die in der schematischen Darstellung recht dick gezeigten Leiterplatten sind in Wirklichkeit meist sehr dünn, z.B. im Bereich von 25 µm oder darunter. Dementsprechend sind sie sehr biegeweich.

Die Vorrichtung 11 weist zwei Behandlungsstationen auf, die aus langgestreckten Behältern bestehen, durch die längs einer horizontalen Transportebene 33 eine Transportvorrichtung 15 verläuft. Zu ihr gehört auch eine zwischen beiden Behandlungsstationen vorgesehene Wendestation 14.

Die Transportvorrichtung weist an ihrem Eingang und Ausgang aus jeder Behandlungsstation 12 Unterbänder 16 auf, auf denen der Gegenstand 17 transportiert wird. Diese Unterbänder übergeben den Gegenstand an darüber angeordnete Oberbänder 18, die zu einer Saugtransporteinrichtung 19 gehören.

Ein Saugkasten 20 ist zwischen Ober- und Untertrum der Oberbänder vorgesehen. Er weist Saugöffnungen 32 an seiner Unterseite auf, über die das untere Trum des ggf. gelochten Oberbands läuft. Der Saugkasten ist über Vakuumleitungen 21 mit einer Vakuumpumpe 22 verbunden. Ggf. ist noch ein nicht dargestellter Flüssigkeitsabscheider, z.B. ein Zyklonabscheider, zwischengeschaltet.

Die Oberbänder 18 erstrecken sich über die gesamte Länge des Behandlungsbereiches jeder Behandlungsstation. Sie sind, ebenso wie die Unterbänder 16, angetrieben.

Im Behandlungsbereich sind unter der Transportebene 33 Sprühdüsen 29 angeordnet, die, in Transportrichtung 34 gesehen, in mehreren Reihen hintereinander liegen. Sie werden von einer Pumpe 28 mit Behandlungsmedium versorgt, das in dem zur Behandlungsstation gehörenden Behälter einen Sumpf bildet.

Bei dem Behandlungsmedium handelt es sich um eine Flüssigkeit, bevorzugt zum Ätzen der beschichteten Leiterplatten. Es könnten jedoch auch andere Behandlungsmedien verwendet werden. Die Vorteile kommen allerdings besonders bei Behandlungen zur Geltung, bei denen eine von Zeit und Spülungsintensität abhängige chemische oder physikalische Behandlung stattfindet. Statt des Aufsprühens der Flüssigkeit könnte sie auch auf andere Weise an den Gegenstand herangebracht werden, beispielsweise in Form von Schwallstrecken. Hier könnten in einer Behandlungsstation 12 mehrere Schwallstrecken hintereinandergeschaltet sein, so daß zwischendrin Flüssigkeit wieder ablaufen oder abtropfen kann.

Die Wendestation 14 besitzt synchron angetriebene Ober- und Unterbänder, die ggf. den Gegenstand auch nur an seinem Rand erfassen. Diese Bänder, die den Gegenstand zwischen sich einspannen, können um eine Wendeachse 23 geschwenkt werden. Diese könnte senkrecht zur Zeichenebene, d.h. horizontal und quer zur Transportrichtung 34, verlaufen. Wenn es erwünscht ist, bei dem Gegenstand 17 zwar Ober- und Unterseite in der Wendestation zu vertauschen, jedoch sie auch um eine vertikale Achse zu drehen, so könnte die Wendeachse 23 auch, wie angedeutet, schräg, z.B. unter 45° zur Zeichenebene geneigt, jedoch in der Transportebene liegend, angeordnet sein.

### Funktion

Die Gegenstände 17 laufen in der Transportebene 33, die am Einlauf 25 von der Oberseite der Unterbänder 16 gebildet wird, in die erste Behandlungsstation 12 ein. Bevor der eigentliche Behandlungsbereich beginnt, werden sie von der Saugtransporteinrichtung 19 übernommen, wobei vor und hinter dem Oberband angeordnete Rollen 35 die Überleitung unterstützen.

Die Vakuumpumpe 22 saugt über die Vakuumleitungen 21 ständig Luft aus dem Saugkasten 20, die durch die Saugöffnungen 32 in diesen einströmt. Über den Saugöffnungen 32 liegt das gelochte Oberband 18. Es ist aber auch möglich, die Saugöffnungen 32 parallel zu ungelochten, relativ schmalen Oberbändern vorzusehen.

Durch die Sprühdüsen 29 wird die Behandlungsflüssigkeit von unten auf den nunmehr mit freier Unterseite hängend geförderten Gegenstand aufgebracht. Sie kann jeweils sofort hinter der Düse wieder abtropfen, so daß bei mehreren ggf. in Gruppen hintereinander angeordneten Düsenreihen mehrfach frische Behandlungsflüssigkeit aufgebracht wird.

Um ein Einsaugen von Behandlungsflüssigkeit in den Saugkasten zu reduzieren, könnten die Saugstrecken, z.B. die Lochungen des Saugkastens, an den jeweils einer Düse oder Düsenreihe gegenüberliegenden Stelle in Zahl und/oder Durchmesser reduziert oder gänzlich weggelassen werden.

In den Saugkasten eingesaugte Behandlungsflüssigkeit wird dort und/oder in dem nachgeschalteten Flüssigkeitsabscheider von der Saugluft abgesondert und in den Kreislauf zurückgeführt.

Da der Saugkasten nur das Untertrum zwischen den beiden Umlenkrollen des Oberbandes erfaßt, endet die Saugwirkung wieder vor dem Auslauf 26, wo der Gegenstand wieder auf ein Unterband 16 übergeben wird.

Von da läuft der Gegenstand in die Wendestation 14, die mit ihren angetriebenen Förderbändern 24 den Gegenstand führt und gleichzeitig aktiv transportiert. Wenn der Gegenstand ganz zwischen den Förderbändern 24 aufgenommen ist, wird die Wendestation um die Wendeachse 23 gedreht, so daß der Gegenstand nun mit der vorher behandelten Seite obenliegend auf das Einlauf-Unterband 16 der zweiten Behandlungsstation 13 gelangt. Dort wird der Behandlungszyklus für die andere Seite des Gegenstandes 17, ebenfalls von unten, durchgeführt.

## Patentansprüche

1. Verfahren zum Behandeln von plattenförmigen Gegenständen (17) mit einem flüssigen Behandlungsmedium (27), insbesondere zum Ätzen von Leiterplatten, bei dem die Gegenstände (17) längs einer Transportebene (33) in wenigstens einer Transportrichtung (34) durch eine Behandlungsstation (12, 13) transportiert werden, in der sie an ihrer Unterseite mit dem Behandlungsmedium (27) behandelt werden, wobei die Gegenstände (17) während der Behandlung durch auf ihre Oberseite einwirkende Saugwirkung gehalten werden, dadurch gekennzeichnet, daß die Gegenstände (17) durch Saugwirkung an einem über ihnen liegenden Förderband (18) gehalten werden.

2. Verfahren nach Anspruch 1, dadurch gekennzeichnet, daß die Gegenstände (17) nach Durchlaufen der Behandlungsstation (12) gewendet und in Transportrichtung (34) einer weiteren Behandlungsstation (13) oder entgegen der Transportrichtung derselben Behandlungsstation (12) zugeführt werden.

3. Verfahren nach Anspruch 1 oder 2, dadurch gekennzeichnet, daß die Behandlung in der Behandlungsstation (12, 13) in mehreren aufeinanderfolgenden Aufbringungen des Behandlungsmediums (27) erfolgt, zwischen denen das Medium (27) von der Unterseite der Gegenstände (17) durch Abfließen und/oder Abtropfen entfernt wird.

4. Vorrichtung zum Behandeln von plattenförmigen Gegenständen (12) mit einem flüssigen Behandlungsmedium (27), insbesondere zum Ätzen von Leiterplatten, mit wenigstens einer Behandlungsstation (12, 13) zur Behandlung einer unten liegenden Seite des Gegenstandes und mit einer Transportvorrichtung (15) für den horizontalen Transport der Gegenstände (17) in einer Transportebene (33) und in einer Transportrichtung (34) durch die Vorrichtung (11), wobei die Transportvorrichtung (15) in der Behandlungsstation (12, 13) eine Saugtransporteinrichtung (19) an der Oberseite der Transportebene (33) aufweist, dadurch gekennzeichnet, daß die Saugtransporteinrichtung (19) ein umlaufendes Förderband (18) und einen über dem Untertrum des Förderbandes (18) angeordneten Saugkasten (20) aufweist.

5. Vorrichtung nach Anspruch 4, dadurch gekennzeichnet, daß das Förderband (18) gelocht ist.

6. Vorrichtung nach Anspruch 4 oder 5, dadurch gekennzeichnet, daß die Saugtransporteinrichtung mit einem Abscheider für das Behandlungsmedium versehen ist.

7. Vorrichtung nach einem der Ansprüche 4 bis 6, dadurch gekennzeichnet, daß die Aufbringung des Behandlungsmediums (27) durch Sprühen erfolgt und in Transportrichtung (34) mehrere Aufbringungsbereiche, vorzugsweise Reihen von Sprühdüsen (29), hintereinander angeordnet sind und zwischen den Aufbringungsbereichen Abtropfbereiche vorgesehen sind.

8. Vorrichtung nach einem der Ansprüche 4 bis 7, dadurch gekennzeichnet, daß in Transportrichtung (34) zwei Behandlungsstationen (12, 13) vorgesehen sind, zwischen denen eine Wendestation (14) zum Wenden der Gegenstände um 180° vorgesehen ist.

9. Vorrichtung nach einem der Ansprüche 4 bis 8, dadurch gekennzeichnet, daß am Auslauf (26) einer Behandlungsstation (12) eine Wendestation (14) vorgesehen ist und die Transportvorrichtung (15) zum Wechsel der Transportrichtung (34) ausgebildet ist.

## Claims

1. Method for treating plate-like articles (17) with a liquid treatment medium (27), particularly for etching printed circuit boards, in which the articles (17) are conveyed along a conveying plane (33) in at least one conveying direction (34) through a treatment station (12, 13), where they are treated on their underside with the treatment medium (27), the articles (17) being held during the treatment by a suction action acting on their upper side, characterized in that, as a result of the suction action, the articles (17) are held on a conveyor belt (18) located above them.

2. Method according to claim 1, characterized in that, after passing through the treatment station (12), the articles (17) are reversed and are supplied in the conveying direction (34) to a further treatment station (13) or, counter to the conveying direction, to the same treatment station (12).

3. Method according to claim 1 or 2, characterized in that the treatment in the treatment station (12, 13) takes place in several successive applications of the treatment medium (27), between which the medium (27) is removed from the bottom of the articles (17) by flowing and/or dripping off.

4. Apparatus for treating plate-like articles (12) with a liquid treatment medium (27), particularly for etching printed circuit boards, with at least one treatment station (12, 13) for treating an underside of the article and with a conveying means (15) for horizontally conveying the articles (17) in a conveying plane (33) and in a conveying direction (34) through the apparatus (11), the conveying means (15) in the treatment station (12, 13) having a suction conveying mechanism (19) on the top of the conveying plane (33), characterized in that the suction conveying mechanism (19) has a revolving conveyor belt (18) and a suction box (20) positioned above the lower strand of the conveyor belt (18).

5. Apparatus according to claim 4, characterized in that the conveyor belt (18) is perforated.

6. Apparatus according to claim 4 or 5, characterized in that the suction conveying mechanism is provided with a separator for the treatment medium.

7. Apparatus according to one of the claims 4 to 6, characterized in that the treatment medium (27) is applied by spraying and in the conveying direction (34) are successively arranged several application areas, preferably rows of spraying nozzles (29) and dripping areas are provided between the application areas.

8. Apparatus according to one of the claims 4 to 7, characterized in that there are two treatment stations (12, 13) in the conveying direction (34) and between said stations there is a reversing station (14) for reversing the articles by 180°.

9. Apparatus according to one of the claims 4 to 8, characterized in that at the outlet (26) of a treatment station (12) is provided a reversing station (14) and the conveying means (15) is constructed for changing the conveying direction (34).

## Revendications

1. Procédé pour le traitement d'objets en forme de plaque (17) avec un agent de traitement liquide (27), notamment pour la gravure de plaquettes imprimées, pour lequel les objets (17) sont transportés au long d'un plan de transport (33) dans au moins une direction de transport (34) à travers une station de traitement (12, 13), dans laquelle ils sont traités sur leur face inférieure avec l'agent de traitement (27), les objets (17) étant tenus durant le traitement par un effet d'aspiration agissant sur leur face supérieure, caractérisé en ce que les objets (17) sont tenus par un effet d'aspiration à une courroie de transport (18) se trouvant au-dessus d'eux.

2. Procédé selon la revendication 1, caractérisé en ce que les objets (17) sont renversés après avoir parcouru la station de traitement (12) et amenés dans la direction de transport (34) à une station de traitement (13) ultérieure ou bien dans la direction opposée à celle du transport à la même station de traitement (12).

3. Procédé selon la revendication 1 ou 2, caractérisé en ce que le traitement a lieu dans la station de traitement (12, 13) en plusieurs applications consécutives de l'agent de traitement (27), entre lesquelles l'agent (27) est enlevé de la face inférieure des objets (17) par écoulement et/ou par égouttage.

4. Dispositif pour le traitement d'objets en forme de plaque (12) avec un agent de traitement liquide (27), notamment pour la gravure de plaquettes imprimées, avec au moins une station de traitement (12, 13) pour le traitement d'une face de l'objet se trouvant sur le côté inférieur et avec un dispositif de transport (15) pour le transport horizontal des objets (17) dans un plan de transport (33) et dans une direction de transport (34) à travers le dispositif (11), le dispositif de transport (15) présentant dans la station de traitement (12, 13) un dispositif de transport à aspiration (19) à la face supérieure du plan de transport (33), caractérisé en ce que le dispositif de transport à aspiration (19) présente une courroie de transport (18) circulante et une caisse aspirante (20) disposée au-dessus du brin inférieur de la courroie de transport (18).

5. Dispositif selon la revendication 4, caractérisé en ce que la courroie de transport (18) est trouée.

6. Dispositif selon la revendication 4 ou 5, caractérisé en ce que le dispositif de transport à aspiration est pourvu d'un séparateur pour l'agent de traitement.

7. Dispositif selon une des revendications de 4 jusqu'à 6, caractérisé en ce que l'application de l'agent de traitement (27) a lieu par aspersion et plusieurs champs d'application, de préférence des rangées de diffuseurs (29) sont disposés l'un derrière l'autre dans la direction de transport (34) et entre les champs d'application sont prévus des champs d'égouttage.

8. Dispositif selon une des revendications de 4 jusqu'à 7, caractérisé en ce que dans la direction de transport (34) sont prévues deux stations de traitement (12, 13), entre lesquelles est prévue une station de renversement (14) pour le renversement des objets de 180°.

9. Dispositif selon une des revendications de 4 jusqu'à 8, caractérisé en ce qu'à la sortie (26) d'une station de traitement (12) est prévue une station de renversement (14) et le dispositif de transport (15) est réalisé pour un changement de la direction de transport (34).
